(19) Europäisches Patentamt
European Patent Office
Office européen des brevets

(11) Veröffentlichungsnummer: **0 393 398 B1**

(12) **EUROPÄISCHE PATENTSCHRIFT**

(45) Veröffentlichungstag der Patentschrift: **29.06.94**

(51) Int. Cl.⁵: **H03K 3/354**, H03K 3/023

(21) Anmeldenummer: **90105978.2**

(22) Anmeldetag: **29.03.90**

(54) **Oszillator in CMOS-Technik.**

(30) Priorität: **03.04.89 DE 3910712**

(43) Veröffentlichungstag der Anmeldung:
**24.10.90 Patentblatt 90/43**

(45) Bekanntmachung des Hinweises auf die Patenterteilung:
**29.06.94 Patentblatt 94/26**

(84) Benannte Vertragsstaaten:
**AT BE CH DE ES FR GB IT LI NL SE**

(56) Entgegenhaltungen:
**EP-A- 0 180 084**
**FR-A- 2 093 826**
**US-A- 4 083 020**

**IBM TECHNICAL DISCLOSURE BULLETIN,
Band 30, Nr. 8, Januar 1988, Seiten 237-238,
Armonk, New York, US; "Improved clamp for
differential VCO and single-shot"**

(73) Patentinhaber: **Alcatel SEL Aktiengesellschaft
Lorenzstrasse 10
D-70435 Stuttgart(DE)**

(84) Benannte Vertragsstaaten:
**BE CH DE ES FR GB IT LI NL SE AT**

(73) Patentinhaber: **ALCATEL N.V.
Strawinskylaan 341,
(World Trade Center)
NL-1077 XX Amsterdam(NL)**

(84) Benannte Vertragsstaaten:
**BE CH**

(72) Erfinder: **Schnabel, Jürgen
Kleine Hasengasse 10
D-7129 Ilsfeld(DE)**

(74) Vertreter: **Pohl, Herbert, Dipl.-Ing et al
Alcatel SEL AG
Patent- und Lizenzwesen
Postfach 30 09 29
D-70449 Stuttgart (DE)**

**Beschreibung**

Die Erfindung geht von einem Oszillator in CMOS-Technik aus.

Ein bekannter CMOS-Kipposzillator (relaxation oscillator) weist einfache CMOS-Inverterstufen als Verstärkungsblöcke auf, die mit einem externen RC-Schwingkreis beschaltet werden. Ferner werden solche CMOS-Kipposzillatoren analog zu emittergekoppelten Multivibratoren mittels einer Vielzahl hintereinandergeschalteter CMOS-Inverterstufen aufgebaut (Grebene, Alan B., Bipolar and MOS analog integrated circuit design, 1983, ISBN O-471-085 29-4, Chapter 11.5, 11.6). Solche Oszillatoren haben den Nachteil, daß sie mit zunehmender Frequenz eine relativ schlechte Temperaturstabilität aufweisen und somit für hohe Frequenzen im Bereich über 30 - 50 MHz nicht brauchbar sind.

Die Druckschriften EP-A-0 180 084 und US-A-4 083 020 offenbaren CMOS-Kipposzillatoren mit einem Differenzverstärker, einem Kondensator und einer einzigen steuerbaren Stromquelle, die mit dem Kondensator verbindbar ist.

Die technische Aufgabe gemäß der Erfindung besteht darin, einen schnellen temperatur- und parameter-konstanten steuerbaren Oszillator in CMOS-Technik für niedrige bis zu sehr hohen Frequenzen, z.B. deutlich über 100 MHz, zu realisieren.

Diese Aufgabe wird erfindungsgemäß durch die Lehre des unabhängigen Anspruchs gelöst.

Der erfindungsgemäße Oszillator ist in monolithisch integrierter CMOS-Technologie realisierbar und weist aufgrund der technologischen Gegebenheiten eine weitgehende Übereinstimmung der Bauelementeeigenschaften auf einen Halbleiterchip, sowie geringe Eingangsströme der Transistoren und einen sehr geringen Stromverbrauch bei gleichzeitig sehr großer Genauigkeit auf.

Insbesondere ist ein solcher erfindungsgemäßer Oszillator als Zelle auf einem größeren CMOS-Chip, z.B. als Bestandteil einer PLL (phase locked loop) sehr universell einsetzbar.

Über die beiden steuerbaren Stromquellen kann die Oszillatorfrequenz völlig linear geändert werden (stromgesteuertes Oszillatorprinzip), wobei durch Variation der Kapazität die Frequenz in sehr weiten Grenzen, d.h. bis zu 200 MHz, verändert werden kann.

Weitere vorteilhafte Ausgestaltungen des Gegenstands der Erfindung sind den abhängigen Ansprüchen zu entnehmen.

Ein Ausführungsbeispiel wird im folgenden anhand der Zeichnungen erläutert. Es zeigen:

Fig. 1 ein Prinzipschaltbild des erfindungsgemäßen Oszillators,

Fig. 2 ein detailliertes Schaltbild des erfindungsgemäßen Oszillators,

Fig. 3 ein Schaltbild einer steuerbaren Stromquelle gemäß der Erfindung und

Fig. 4 Zeitdiagramm zur Erläuterung der Funktionsweise des erfindungsgemäßen Oszillators.

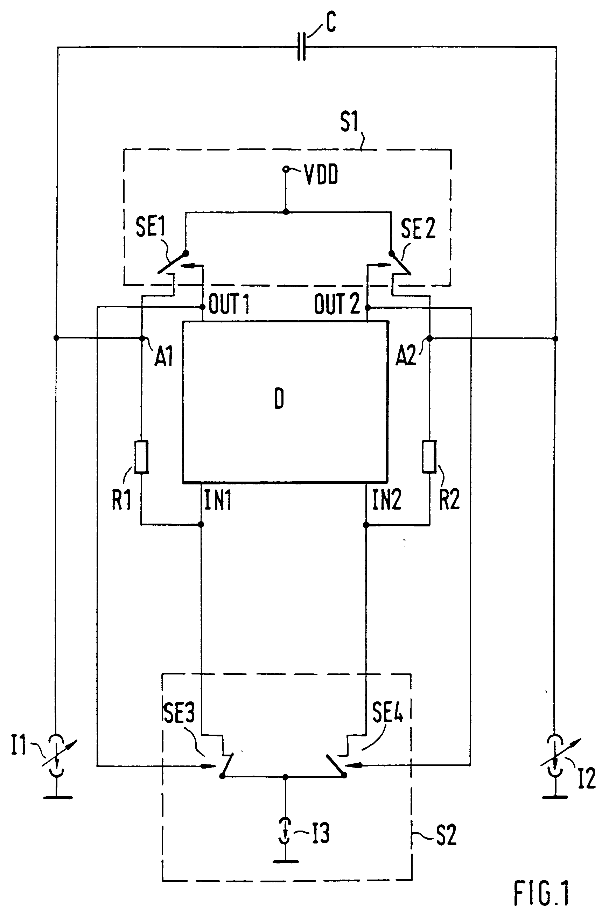

Ein in CMOS-Technologie aufgebauter erfindungsgemäßer Oszillator, wie in Figur 1 gezeigt, weist einen Differenzverstärker D, eine erste Schalteinheit S1, bestehend aus einem ersten Schaltelement SE1 und einem zweiten Schaltelement SE2, eine zweite Schalteinheit S2, bestehend aus einem dritten Schaltelement SE3 und aus einem vierten Schaltelement SE4, eine erste steuerbare Stromquelle I1 und eine zweite steuerbare Stromquelle I2 auf. Die beiden steuerbaren Stromquellen I1, I2 sind über einen Kondensator C zusammengeschaltet.

Weiterhin ist die erste Stromquelle I1 über einen ersten ohmschen Widerstand R1 mit einem ersten Eingang IN1 des Differenzverstärkers D und die zweite Stromquelle I2 über eine zweiten ohmschen Widerstand R2 mit einem zweiten Eingang IN2 des Differenzverstärkers D verbunden.

Ein mit VDD bezeichneter, Versorgungsspannung (+5V) führender Anschluß ist über den Schaltweg des ersten Schaltelements SE1 oder über den Schaltweg des zweiten Schaltelements SE2 mit einem ersten, zwischen der ersten Stromquelle I1 und dem ersten Widerstand R1 liegenden Abgriff A1 bzw. mit einem zweiten, zwischen der zweiten Stromquelle I2 und dem zweiten Widerstand R2 liegenden Abgriff A2 verbindbar.

Ferner ist ein erster Ausgang OUT1 und ein zweiter Ausgang OUT2 des Differenzverstärkers D mit einem Schalteingang des ersten Schaltelements SE1 bzw. mit einem Schalteingang des zweiten Schaltelementes SE2 verbunden.

Entweder der erste Eingang IN1 oder der zweite Eingang IN2 des Differenzverstärkers D sind über einen Schaltweg des dritten Schaltelementes SE3 bzw. über einen Schaltweg des vierten Schaltelementes SE4 mit einer dritten, ebenfalls in CMOS-Technik aufgebauten Stromquelle I4 verbindbar. Ein Steuereingang des dritten Schaltelements SE3 und ein Steuereingang des vierten Schaltelementes SE4 sind mit dem ersten Ausgang OUT1 bzw. mit dem zweiten Ausgang OUT2 des Differenzverstärkers D verbunden.

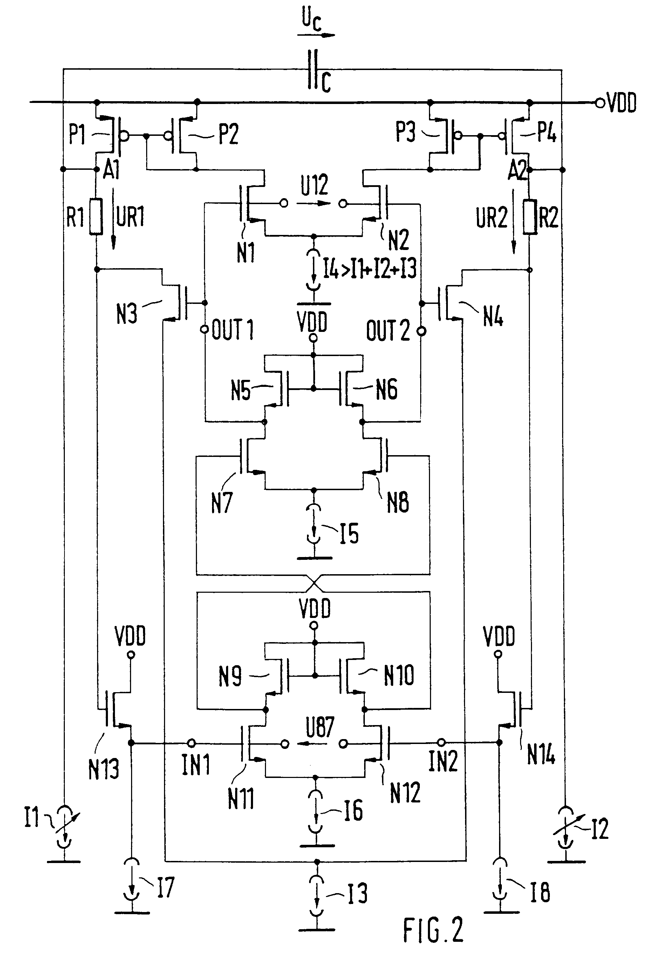

Im folgenden wird anhand der Figur 2 detailliert eine mögliche Ausführungsform des erfindungsgemäßen Oszillators beschrieben.

Die erste Schalteinheit S1 besteht aus einem das erste Schaltelement SE1 bildenden ersten NMOS-Transistor N1 und aus einem das zweite Schaltelement SE2 bildenden zweiten NMOS-Transistor N2, sowie aus einer ersten und einer zweiten Stromspiegelschaltung.

Die erste Stromspiegelschaltung ist aus einem ersten PMOS-Transistor P1 und einem zweiten PMOS-Transistor P2 aufgebaut. Die beiden Drainanschlüsse sind mit dem Versorgungsspannung führenden Anschluß VDD verbunden. Die beiden Gateanschlüsse sind zusammengeschaltet und der Sourceanschluß des zweiten PMOS-Transistors P2 ist auf die zusammengeschalteten Gateanschlüsse zurückgekoppelt sowie mit dem Drainanschluß des ersten NMOS-Transistors N1 verbunden. Der Sourceanschluß des ersten PMOS-Transistors P1 ist mit dem ersten Abgriff A1 verbunden.

Die zweite Stromspiegelschaltung besteht aus einem dritten PMOS-Transistor P3 und einem vierten PMOS-Transistor P4 und ist symmetrisch zur ersten Stromspiegelschaltung aufgebaut und entsprechend mit dem zweiten NMOS-Transistor N2 (Sourceanschluß von P3 an Drainanschluß von N2) und dem zweiten Abgriff A2 (verbunden mit dem Sourceanschluß von P4) verbunden.

Die Sourceanschlüsse des ersten und zweiten NMOS-Transistors N1, N2 sind zusammengeschaltet und mit der vierten Stromquelle I4 verbunden. Der Gateanschluß des ersten NMOS-Transistors N1 und der Gateanschluß des zweiten NMOS-Transistors N2 bilden den Steuereingang des ersten Schaltelements SE1 bzw. den Steuereingang des zweiten Schaltelements SE2 (vgl. Figur 1).

Die zweite Schalteinheit S2 weist einen das dritte Schaltelement bildenden dritten NMOS-Transistor N3 und einen das vierte Schaltelement bildenden vierten NMOS-Transistor N4 auf. Der Drainanschluß des dritten NMOS-Transistors N3 und der Drainanschluß des vierten NMOS-Transistors N4 sind mit dem von dem ersten Abgriff A1 abgewandten Anschluß des ersten Widerstandes R1 bzw. mit dem von dem zweiten Abgriff A2 abgewandten Anschluß des zweiten Widerstandes R2 verbunden. Weiterhin sind die beiden Sourceanschlusse (von N3 und N4) zusammengeschaltet und mit der dritten Stromquelle I3 verbunden. Der Gateanschluß des dritten NMOS-Transistors N3 und der Gateanschluß des vierten NMOS-Transistors N4 bilden den Steuereingang des dritten Schaltelements SE3 bzw. den Steuereingang des vierten Schaltelements SE4 (vgl. Figur 1).

Der Differenzverstärker D ist gemäß Figur 2 als kaskadierte zweistufige Verstärkerschaltung ausgelegt. Eine erste Differenzverstärkerstufe besteht aus einem fünften, sechsten, siebten und achten NMOS-Transistor N5, N6, N7, N8 sowie aus einer fünften, in CMOS-Technik aufgebauten Stromquelle I5. Analog dazu besteht eine zweite Differenzverstärkerstufe aus einem neunten, zehnten, elften und zwölften NMOS-Transistor N9, N10, N11, N12 sowie aus einer sechsten, in CMOS-Technik aufgebauten Stromquelle I6.

Die Drainanschlüsse sowie die zusammengeschalteten Gateanschlüsse von N5 und N6 sind mit dem Versorgungsspannungsanschluß VDD verbunden. Der Sourceanschluß von N5 und der Soruceanschluß von N6 bilden den erSten Ausgang OUT1 bzw. den zweiten Ausgang OUT2 des Differenzverstärkers D (vgl. auch Figur 1). Die beiden Transistoren N5, N6 stellen die beiden Lastwiderstände eines üblichen Differenzverstärkers dar. Die Sourceanschlüsse von N7 und N8 sind zusammengeschaltet und mit der fünften Stromquelle I5 verbunden. Der Drainanschluß von N7 und der Drainschluß von N8 ist mit dem Sourceanschluß von N5 bzw. mit dem Sourceanschluß von N6 verbunden. Der Gateanschluß von N7 und der Gateanschluß von N8 bilden einen ersten Ausgang bzw. einen zweiten Ausgang der ersten Differenzverstärkerstufe. Die beiden NMOS-Transistoren stellen dabei die erste Verstärkerstufe des Differenzverstärkers dar.

Die zweite Differenzverstärkerstufe ist analog zur ersten Differenzverstärkerstufe aufgebaut, wobei der neunte NMOS-Transistor N9 und der zehnte NMOS-Transistor N10 entsprechend die beiden Lastwiderstände darstellen und der elfte NMOS-Transistor N11 und der zwölfte NMOS-Transistor N12 die eigentliche zweite Verstärkerstufe bilden (vgl. Figur 2).

Der Drainanschluß von N11 und der Drainschluß von N12 sind mit dem zweiten Ausgang bzw. dem ersten Ausgang der ersten Differenzverstärkerstufe verbunden. Ferner bilden der Gateanschluß von N11 und der Gateanschluß von N12 den ersten Eingang IN1 bzw. den zweiten Eingang IN2 des Differenzverstärkers D.

Weiterhin sind, wie Figur 2 zeigt, die erste steuerbare Stromquelle I1 und die zweite steuerbare Stromquelle I2 über den frequenzbestimmenden Kondensator C zusammengeschaltet. Die erste Stromquelle I1 und die zweite Stromquelle I2 sind über den ersten Widerstand R1 mit dem Drainanschluß von N3 bzw. über den zweiten Widerstand R2 mit dem Drainanschluß von N4 verbunden.

Gemäß einer vorteilhaften Ausgestaltung der Erfindung ist der erste Widerstand R1 mit seinem dem ersten Abgriff A1 abgewandten Anschluß mit dem Gateanschluß eines dreizehnten NMOS-Transistors N13 und der zweite Widerstand R2 mit seinem dem zweiten Abgriff A2 abgewandten Anschluß mit dem Gateanschluß eines vierzehnten NMOS-Transistors N14 verbunden. Der Drainschluß von N13 und der Drainanschluß von N14 sind mit dem Versorgungsspannung führenden Anschluß VDD verbunden. Der Sourceanschluß von N13 ist mit dem Gateanschluß von N11, d.h. mit dem ersten Eingang IN1 des Differenzverstärkers D sowie mit einer siebten, in CMOS-Technik aufgebauten Stromquelle I7 verbunden. Analog dazu ist der Sourceanschluß von N14 mit dem Gateanschluß von N12, d.h. mit dem zweiten Eingang IN2 des Differenzverstärkers D, sowie mit einer achten, in CMOS-Technik aufgebauten Stromquelle I8 verbunden.

Der dreizehnte NMOS-Transistor N13 und der vierzehnte NMOS-Transistor N11 bilden sogenannte Sourcefolgerstufen, die gegenüber den nachfolgenden Differenzverstärker-Transistoren N11 bzw. N12 eine um etwa den Faktor 5 bis 10 kleinere Eingangskapazität aufweisen, so daß das über den ersten ohmschen Widerstand R1 bzw. über den zweiten ohmschen Widerstand R2 gebildete RC-Produkt vernachlässigbar klein wird.

Die siebte Stromquelle I7 und die achte Stromquelle I8 dienen zur Arbeitspunkteinstellung von N13 bzw. N14. Durch die Ansteuerung von N13 und N14 mittels der Ströme I7 bzw. I8 wird eine Gate-Source-Spannung an N13 bzw. N14 aufgebaut, die den Betrieb der nachfolgenden Differenzverstärker-Transistoren N11, N12 im Abschnürbereich der Transistorkennlinie ermöglicht, welcher infolge seiner höheren Steilheit und damit Verstärkung dem Anlaufbereich der Kennlinie vorzuziehen ist.

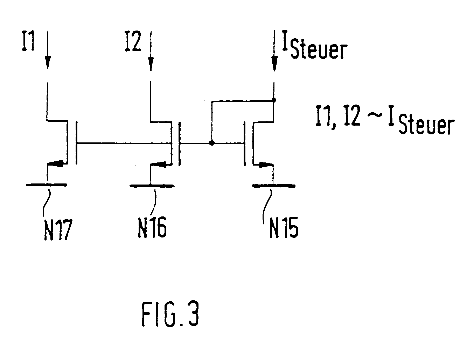

Ein Aufbau der steuerbaren Stromquelle I1, I2 wird im folgenden anhand der Figur 3 erläutert. Die Stromquelle weist zwei als Stromspiegel geschaltete NMOS-Transistoren N15, N16 auf, wobei N15 den Ausgangsstrompfad für die zweite Stromquelle bildet. Ein siebzehnter NMOS-Transistor N17, dessen Gateanschluß mit dem Gateanschluß von N16 verbunden ist, bildet den Ausgangsstrompfad für die erste Stromquelle I1. Die Ausgangsströme I1 und I2 der beiden Stromquellen sind, entsprechend dem Spiegelverhältnis, proportional zum Steuerstrom, wobei hier zur symmetrischen Auslegung des Oszillators ein Spiegelverhältnis von 1, d.h. gleich große Ausgangsströme I1 und I2, gewählt werden. Über die Ströme I1 und I2 kann die Oszillatorfrequenz linear geändert werden.

Der Oszillator arbeitet mit einer Versorgungsspannung VDD von +5V. Ferner sind die beiden ohmschen Widerstände R1, R2 betragsgemäß gleich groß zu R1 = R2 = 1 k gewählt. Die beiden gesteuerten Stromquellen geben einen Strom im Milliampère-Bereich ab, und der Spannungshub der Schaltung (Spannungsabfall an den Widerständen) liegt im Bereich von einigen hundert Millivolt. Außerdem weisen die Differenzverstärkerstufen je einen Verstärkungsfaktor im Bereich von 2 bis 10 auf, und zur Erreichung von Frequenzen wesentlich oberhalb von 100 MHz weist der Kondensator C eine Kapazität im Picofarad-Bereich auf. Ferner ist die vierte Stromquelle I4 so dimensioniert, daß sie betragsmäßig einen Strom I4 liefert, der etwas größer ist, als die Summe der Beträge der ersten, der zweiten und der dritten Stromquelle (vgl. Figur 2).

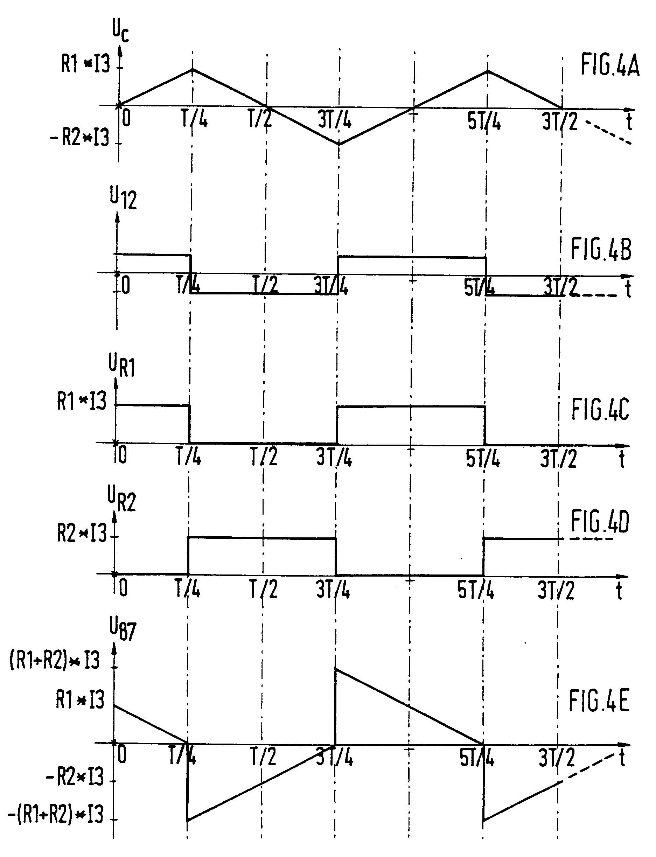

Die Erläuterung der Funktion des erfindungsgemäßen Oszillators erfolgt nun mit Hilfe der Zeitdiagramme der Figur 4.

In der ersten Zeile - a - ist der Spannungsverlauf UC am Kondensator C über der Zeit t dargestellt, wobei die Kondensatorspannung UC in einem ersten Umschaltpunkt gleich dem Spannungsabfall am ersten Widerstand R1 (UC = R1 x I3) oder in einem zweiten Umschaltpunkt gleich dem Spannungsabfall (Hub) am zweiten Widerstand R2 (UC = R2 x I3) ist.

In der zweiten Zeile - b - ist der Spannungsverlauf U12 zwischen dem ersten und dem zweiten Schaltelement SE1, SE2 der ersten Schalteinheit S1 über der Zeit t dargestellt (zu U12, vgl. Figur 2).

In der dritten Zeile - c - ist der Spannungshub UR1 am ersten ohmschen Widerstand R1 über der Zeitachse t und in der vierten Zeile - d - ist der Spannungshub UR2 am zweiten ohmschen Widerstand R2 über der Zeitachse t aufgezeigt.

Schließlich ist in der fünften Zeile - e - der Spannungsverlauf U87 an den Differenzverstärkereingängen IN1, IN2 über der Zeit t dargestellt. Die Zeitachse t ist jweils in die Zeitabstände 0, 1/4, 1/2, 3/4 ... der Zeitdauer T der Oszillatorfrequenz f unterteilt. Die Oszillatorfrequenz f berechnet sich bei einem symmetrischen Schaltungsaufbau (d.h. I1 = I2, R1 = R2) zu

$$f = I1/4 \times C \times R1 \times I3.$$

Ausgehend von einem ungeladenen Kondensator C (UC = 0) und von einem Zeitpunkt t = 0 (vgl. Figur 4) ist in einem ersten Kippzustand ein erster Strompfad aus erster Stromspiegelschaltung P1, P2, aus erstem Schaltelement N1 (vgl. Figur 4b, U12 > 0) und aus erster Differenzverstärkerstufe (N7 leitend) und zweiter Differenzverstärkerstufe (N12 leitend) durchgeschaltet (U87 > 0 in Fig. 4e). Dies bewirkt, daß das dritte Schaltelement SE3, d.h. der dritte NMOS-Transistor N3, ebenfalls leitend ist, so daß am ersten Widerstand R1 eine Spannung UR1 = I3 x R1 (vgl. Fig. 4c) anliegt.

Dadurch, daß der vierte NMOS-Transistor N4 (vgl. Figur 2) in dem ersten Kippzustand nicht leitend ist und bei gleichzeitiger Voraussetzung, daß N13 und N14 gleichartig sind und damit den gleichen Gate-Source-Spannungsabfall aufweisen, ist zunächst zum Zeitpunkt t = 0 der Spannungsabfall UR1 am ersten Widerstand R1 gleich dem Spannungsabfall U87 zwischen den Differenzverstärkereingängen (vgl. Figur 4c und 4e).

Da P1 leitend ist und gleichzeitig P4, d.h. die zweite Stromspiegelschaltung nicht leitend ist (U12 > 0), wird jetzt der Kondensator C durch den Strom I2 der zweiten Stromquelle I2 aufgeladen (vgl. Figur 4a). Entsprechend verringert sich die Spannung U87 an den Differenzverstärkereingängen (vgl. Figur 4e), und zwar bis zum Zeitpunkt t = T/4 die Kondensatorspannung UC auf den Wert UR1 = R1

x I3 aufgeladen und U87 = 0 wird (vgl. Figur 4a, 4e).

Jetzt "kippt" die Schaltung in den zweiten Kippzustand um. Da jetzt U12 < 0 gilt, ist der erste Strompfad gesperrt und ein zweiter Strompfad aus zweiter Stromspiegelschaltung P3, P4 aus zweitem NMOS-Transistor N2, d.h. zweites Schaltelement SE2, und aus erster Differenzverstärkerstufe (N8 leitend) sowie zweiter Differenzverstärkerstufe (N11 leitend) durchgeschaltet (vgl. Fig. 4b, 4e, da U87 < 0). Am zweiten Widerstand R2 fällt jetzt die Spannung UR2 = R2 x I3 ab (vgl. Fig. 4d).

Somit wird der Kondensator C entladen (vgl. Fig. 4a), und zwar solange, bis zum Zeitpunkt t = 3 T/4 die Kondensatorspannung UC = -UR2 = -R2 x I3 ist (vgl. Fig. 4a), so daß die Schaltung wieder in den ersten Kippzustand übergeht (vgl. Fig. 4b jetzt U12 > 0, Fig. 4c jetzt UR1 = R1 x I3) und im Zeitpunkt t = T der Anfangszustand mit UC = 0 erreicht wird. Dieser zuvor beschriebene Oszillatorzyklus setzt sich entsprechend fort.

Der zuvor geschilderte Oszillator ist zwischen sehr niedrigen Frequenzen und etwa 200 MHz einsetzbar. Er ermöglicht eine in weiten Bereichen lineare Steuerung der Ausgangsfrequenz. Er zeichnet sich gegenüber herkömmlichen Bipolar-Oszillatoren durch einen sehr geringen Stromverbrauch und eine wesentlich höhere Genauigkeit aus. Ferner weist er im Vergleich zu bekannten CMOS-Oszillatoren aufgrund seines einfachen symmetrischen Aufbaus eine wesentlich bessere Temperatur- und Parameterkonstanz auf, da sich die einzelnen Einflußfaktoren gegenseitig aufheben. Außerdem ist ein um eine Zehnerpotenz höherer Frequenzbereich einstellbar.

Ein besonderer Vorteil liegt in der Integrierbarkeit dieser CMOS-Schaltung auf hochintegrierten, digitalen CMOS-Chips, welche bisher zusätzlich externe bipolare spannungsgesteuerte Oszillatoren (VCO) zum Erreichen der notwendigen Genauigkeit und der sehr hohen Frequenzen benötigten.

Selbstverständlich kann der zuvor geschilderte Oszillator auch komplementär aufgebaut werden (d.h. anstelle PMOS- werden NMOS-Transistoren verwendet und umgekehrt).

**Patentansprüche**

1. Oszillator in CMOS-Technik, mit
   - einem Differenzverstärker (D),
   - einer ersten Schalteinheit (S1) aus einem ersten Schaltelement (SE1) und einem zweiten Schaltelement (SE2),
   - einer zweiten Schalteinheit (S2) aus einem dritten Schaltelement (SE3) und einem vierten Schaltelement (SE4)
   - einer ersten (I1) und einer zweiten steuerbaren Stromquelle (I2), die über einen Kondensator (C) zusammengeschaltet sind,
   - und mit einem Aufbau wie folgt
   - die erste Stromquelle (I1) ist über einen ersten ohmschen Widerstand (R1) mit einem ersten Eingang (IN1) des Differenzverstärkers (D) verbunden und die zweite Stromquelle (I2) ist über einen zweiten ohmschen Widerstand (R2) mit einem zweiten Eingang (IN2) des Differenzverstärkers (D) verbunden,
   - ein Versorgungsspannung führender Anschluß (VDD) ist über den Schaltweg des ersten Schaltelementes (SE1) mit einem ersten, zwischen der ersten Stromquelle (I1) und dem ersten Widerstand (R1) liegenden Abgriff (A1) verbindbar und über den Schaltweg des zweiten Schaltelementes (SE2) mit einem zweiten, zwischen der zweiten Stromquelle (I2) und dem zweiten Widerstand (R2) liegenden Abgriff (A2) verbindbar,
   - ein erster Ausgang (OUT1) des Differenzverstärkers (D) ist mit einem Schalteingang des ersten Schaltelementes (SE1) verbunden und ein zweiter Ausgang (OUT2) des Differenzverstärkers (D) ist mit einem Schalteingang des zweiten Schaltelementes (SE2) verbunden,
   - der erste Eingang (IN1) des Differenzverstärkers (D) ist über einen Schaltweg des dritten Schaltelements (SE3) und der zweite Eingang (IN2) des Differenzverstärkers (D) ist über einen Schaltweg des vierten Schaltelements (SE4) mit einer dritten, in CMOS-Technik aufgebauten Stromquelle (I3) verbindbar, und
   - ein Steuereingang des dritten Schaltelementes (SE3) ist mit dem ersten Ausgang (OUT1) des Differenzverstärkers (D) und ein Steuereingang des vierten Schaltelementes (SE4) ist mit dem zweiten Ausgang (OUT2) des Differenzverstärkers (D) verbunden.

2. Oszillator nach Anspruch 1, mit folgender Merkmalskombination
   - die erste Schalteinheit (S1) ist aus einem das erste Schaltelement (SE1) bildenden ersten NMOS-Transistor (N1), aus einem das zweite Schaltelement (SE2) bildenden zweiten NMOS-Transistor (N2), aus einer aus einem ersten PMOS-Transistor (P1) und einem zweiten PMOS-Transistor (P2) aufgebauten ersten Stromspiegelschaltung und aus einer aus einem dritten PMOS-Transistor (P3) und einem vierten PMOS-Transistor (P4) aufgebauten zweiten Stromspiegelschaltung aufgebaut,

- der Ausgangsstromzweig (Drain von P1) der ersten Stromspiegelschaltung ist mit dem ersten Abgriff (A1) und der Ausgangsstromzweig (Drain von P4) der zweiten Stromspiegelschaltung ist mit dem zweiten Abgriff (A2) verbunden,
- der Referenzstromzweig der ersten Stromspiegelschaltung ist über den Schaltweg des ersten NMOS-Transistors (N1) und der Referenzstromzweig der zweiten Stromspiegelschaltung ist über den Schaltweg des zweiten NMOS-Transistors (N2) mit einer vierten, in CMOS-Technik aufgebauten Stromquelle (I4) verbindbar und
- der Gateanschluß des ersten NMOS-Transistors (N1) bildet den Steuereingang des ersten Schaltelementes (SE1) und der Gateanschluß des zweiten NMOS-Transistors (N2) bildet den Steuereingang des zweiten Schaltelementes (SE2).

3. Oszillator nach Anspruch 1 oder 2, mit folgender Merkmalskombination
- die zweite Schalteinheit (S2) ist aus einem das dritte Schaltelement (SE3) bildenden dritten NMOS-Transistor (N3) und aus einem das vierte Schaltelement (SE4) bildenden vierten NMOS-Transistor (N4) aufgebaut,
- der erste Widerstand (R1) ist über den Schaltweg des dritten NMOS-Transistors (N3) und der zweite Widerstand (R2) ist über den Schaltweg des vierten NMOS-Transistors (N4) mit der dritten Stromquelle (I3) verbindbar und
- der Gateanschluß des dritten NMOS-Transistors (N3) ist mit dem ersten Ausgang (OUT1) verbunden und der Gateanschluß des vierten NMOS-Transistors (N4) ist mit dem zweiten Ausgang (OUT2) des Differenzverstärkers (D) verbunden.

4. Oszillator nach einem der vorhergehenden Ansprüche, mit folgender Merkmalskombination
- der Differenzverstärker (D) ist aus einer ersten Differenzverstärkerstufe (N5, N6, N7, N8, 15) und aus einer zweiten Differenzverstärkerstufe (N9, N10, N11, N12, 16) aufgebaut, die in Kaskade geschaltet sind.

5. Oszillator nach Anspruch 4, mit folgender Merkmalskombination
- die erste Differenzverstärkerstufe enthält einen fünften NMOS-Transistor (N5) und einen sechsten NMOS-Transistor (N6), deren Gateanschlüsse und deren Drainanschlüsse mit dem Versorgungsspannung führenden Anschluß (VDD) verbunden sind,
- der Sourceanschluß des fünften NMOS-Transistors (N5) bildet den ersten Ausgang (OUT1) und der Sourceanschluß des sechsten NMOS-Transistors (N6) bildet den zweiten Ausgang (OUT2) des Differenzverstärkers (D),
- die erste Differenzverstärkerstufe enthält einen siebten (N7) und einen achten NMOS-Transistor, deren Sourceanschlüsse mit einer in CMOS-Technik aufgebauten fünften Stromquelle (I5) verbunden sind,
- der Drainanschluß des siebten NMOS-Transistors (N7) ist mit dem Sourceanschluß des fünften des fünften NMOS-Transistors (N5) verbunden und der Drainanschluß des achten NMOS-Transistors (N8) ist mit dem Sourceanschluß des sechsten NMOS-Transistors (N6) verbunden und
- der Gateanschluß des siebten NMOS-Transistors (N7) bildet einen ersten Eingang und der Gateanschluß des achten NMOS-Transistors (N8) bildet einen zweiten Eingang der ersten Differenzverstärkerstufe.

6. Oszillator nach Anspruch 5, mit folgender Merkmalskombination
- die zweite Differenzverstärkerstufe enthält einen neunten NMOS-Transistor (N9) und einen zehnten NMOS-Transistor (N10), deren Gateanschlüsse und deren Drainanschlüsse mit dem Versorgungsspannung führenden Anschluß (VDD) verbunden sind,
- der Sourceanschluß des neunten (N9) ist mit dem zweiten Eingang und der Sourceanschluß des zehnten NMOS-Transistors (N10) ist mit dem ersten Eingang der ersten Differenzverstärkerstufe (N5, N6, N7, N8, 15) verbunden,
- die zweite Differenzverstärkerstufe enthält einen elften NMOS-Transistor (N11) und einen zwölften NMOS-Transistor (N12), deren Sourceanschlüsse mit einer in CMOS-Technik aufgebauten sechsten Stromquelle (I6) verbunden sind,

- der Drainanschluß des elften NMOS-Transistors (N11) ist mit dem Sourceanschluß des neunten NMOS-Transistors (N9) verbunden und der Drainanschluß des zwölften NMOS-Transistors (N12) ist mit dem Sourceanschluß des zehnten NMOS-Transistors (N10) verbunden und
- der Gateanschluß des elften NMOS-Transistors (N11) bildet den ersten Eingang (IN1) und der Gateanschluß des zwölften NMOS-Transistors (N12) bildet den zweiten Eingang (IN2) des Differenzverstärkers (D).

7. Oszillator nach einem der vorhergehenden Ansprüche, mit folgender Merkmalskombination
- der dem ersten Abgriff (A1) abgewandte Anschluß des ersten Widerstandes (R1) ist mit dem Gateanschluß eines dreizehnten NMOS-Transistors (N13) verbunden und der dem zweiten Abgriff (A2) abgewandte Anschluß des zweiten Widerstandes (R2) ist mit dem Gateanschluß eines vierzehnten NMOS-Transistors (N14) verbunden,
- die Drainanschlüsse des dreizehnten und vierzehnten NMOS-Transistors (N14) sind mit dem Versorgungsspannung führenden Anschluß (VDD) verbunden,
- der Sourceanschluß des dreizehnten NMOS-Transistors (N13) ist mit dem ersten Eingang (IN1) des Differenzverstärkers (D) und mit einer in CMOS-Technik aufgebauten siebten Stromquelle (I7) verbunden und
- der Sourceanschluß des vierzehnten NMOS-Transistors (N14) ist mit dem zweiten Eingang (IN2) des Differenzverstärkers (D) und mit einer in CMOS-Technik aufgebauten achten Stromquelle (I8) verbunden.

8. Oszillator nach Anspruch 2, der so dimensioniert ist, daß die vierte Stromquelle (I4) betragsmäßig einen größeren Strom liefert, als der Strom aus der Summe der ersten, zweiten und dritten Stromquelle beträgt.

9. Oszillator nach einem der vorhergehenden Ansprüche, mit folgender Merkmalskombination
- die erste steuerbare Stromquelle (I1) und die zweite steuerbare Stromquelle (I2) sind identisch aufgebaut und liefern gleiche Ströme und
- der erste ohmsche Widerstand (R1) und der zweite ohmsche Widerstand (R2) weisen gleiche Widerstandswerte auf.

10. Oszillator nach einem der vorhergehenden Ansprüche, wobei der Oszillator in komplementärer CMOS-Technik aufgebaut ist.

**Claims**

1. An oscillator in CMOS technology having
- a differential amplifier (D),
- a first switching unit (S1) containing a first switching element (SE1) and a second switching element (SE2),
- a second switching unit (S2) containing a third switching element (SE3) and a fourth switching element (SE4), and
- a first controlled current source (I1) and a second controlled current source (I2) interconnected via a capacitor (C), and
- a configuration as follows:
- The first current source (I1) is connected via a first resistor (R1) to a first input (IN1) of the differential amplifier (D), and the second current source (I2) is connected via a second resistor (R2) to a second input (IN2) of the differential amplifier (D);
- a supply-voltage terminal (VDD) is connectable via the switching path of the first switching element (SE1) to a first tap (A1) located between the first current source (I1) and the first resistor (R1), and via the switching path of the second switching element (SE2) to a second tap (A2) located between the second current source (I2) and the second resistor (R2);
- a first output (OUT1) of the differential amplifier (D) is connected to a control input of the first switching element (SE1), and a second output (OUT2) of the differential amplifier (D) is connected to a control input of the second switching element (SE2);
- the first input (IN1) of the differential amplifier (D) is connectable to a third CMOS current source (I3) via a switching path of the third switching element (SE3), and the second input (IN2) of the differential amplifier (D) is connectable to the third CMOS current source (I3) via a switching path of the fourth switching element (SE4), and
- a control input of the third switching element (SE3) is connected to the first output (OUT1) of the differential amplifier (D), and a control input of the fourth switching element (SE4) is connected to the second output (OUT2) of the differential amplifier (D).

2. An oscillator according to claim 1 with the following combination of features:
- The first switching unit (S1) contains a first NMOS transistor (N1) forming the first switching element (SE1), a second NMOS transistor (N2) forming the second switching element (SE2), a first current mirror made up of a first PMOS transistor (P1) and a second PMOS transistor (P2), and a second current mirror made up of a third PMOS transistor (P3) and a fourth PMOS transistor (P4);
- the output current path (drain of P1) of the first current mirror is connected to the first tap (A1), and the output current path (drain of P4) of the second current mirror is connected to the second tap (A2);
- the reference current path of the first current mirror is connectable to a fourth CMOS current source (I4) via the drain-source path of the first NMOS transistor (N1), and the reference current path of the second current mirror is connectable to the fourth CMOS current source via the drain-source path of the second NMOS transistor (N2), and
- the gate terminal of the first NMOS transistor (N1) forms the control input of the first switching element (SE1), and the gate terminal of the second NMOS transistor (N2) forms the control input of the second switching element (SE2).

3. An oscillator according to claim 1 or 2 with the following combination of features:
- The second switching unit (S2) contains a third NMOS transistor (N3), forming the third switching element (SE3), and a fourth NMOS transistor (N4), forming the fourth switching element (SE4);
- the first resistor (R1) is connectable to the third current source (I3) via the drain-source path of the third NMOS transistor (N3), and the second resistor (R2) is connectable to the third current source (I3) via the drain-source path of the fourth NMOS transistor (N4), and
- the gate terminal of the third NMOS transistor (N3) is connected to the first output (OUT1) of the differential amplifier (D), and the gate terminal of the fourth NMOS transistor (N4) is connected to the second output (OUT2) of the differential amplifier (D).

4. An oscillator according to any one of the preceding claims with the following combination of features:
- The differential amplifier (D) is made up of a first differential amplifier stage (N5, N6, N7, N8, 15) and a second differential amplifier stage (N9, N10, N11, N12, 16) which are connected in cascade.

5. An oscillator according to claim 4 with the following combination of features:
- The first differential amplifier stage comprises a fifth NMOS transistor (N5) and a sixth NMOS transistor (N6) having their gate and drain terminals connected to the supply-voltage terminal (VDD);
- the source terminal of the fifth NMOS transisor (N5) forms the first output (OUT1) of the differential amplifier (D), and the source terminal of the sixth NMOS transistor (N6) forms the second output (OUT2) of the differential amplifier (D);
- the first differential amplifier stage comprises a seventh NMOS transistor (N7) and an eighth NMOS transistor (N8) having their source terminals connected to a fifth CMOS current source (I5);
- the drain terminal of the seventh NMOS transistor (N7) is connected to the source terminal of the fifth NMOS transistor (N5) and the drain terminal of the eighth NMOS transistor (N8) is connected to the source terminal of the sixth NMOS transistor (N6), and
- the gate terminal of the seventh NMOS transistor (N7) forms a first input of the first differential amplifier stage, and the gate terminal of the eighth NMOS transistor (N8) forms a second input of the first differential amplifier stage.

6. An oscillator according to claim 5 with the following combination of features:
- The second differential amplifier stage contains a ninth NMOS transistor (N9) and a tenth NMOS transistor (N10) having their gate and drain terminals connected to the supply-voltage terminal (VDD);
- the source terminal of the ninth NMOS transistor (N9) is connected to the second output of the first differential amplifier stage (N5, N6, N7, N8, 15), and the source terminal of the tenth NMOS transistor (N10) is connectd to the first input of the first differential amplifier stage (N5, N6, N7, N8, 15);
- the second differential amplifier stage comprises an eleventh NMOS transistor (N11) and a twelfth NMOS transistor (N12) having their source terminals connected to a sixth CMOS current source (I6);
- the drain terminal of the eleventh NMOS transistor (N11) is connected to the source terminal of the ninth NMOS transistor (N9), and the drain terminal of the twelfth NMOS transistor (N12) is connected to the source terminal of the tenth NMOS transistor (N10), and
- the gate terminal of the eleventh NMOS transistor (N11) forms the first input (IN1) of the differential amplifier (D), and the gate terminal of the twelfth NMOS transistor (N12) forms the second input (IN2) of the differential amplifier (D).

7. An oscillator according to any one of the preceding claims with the following combination of features:
- The terminal of the first resistor (R1) remote from the first tap (A1) is connected to the gate terminal of a thirteenth NMOS transistor (N13), and the terminal of the second resistor (R2) remote from the second tap (A2) is connected to the gate terminal of a fourteenth NMOS transistor (N14);
- the drain terminals of the thirteenth NMOS transistor (N13) and the fourteenth NMOS transistor (N14) are connected to the supply-voltage terminal (VDD);
- the source terminal of the thirteenth NMOS transistor (N13) is connected to the first input (IN1) of the differential amplifier (D) and to a seventh CMOS current source (I7), and
- the source terminal of the fourteenth NMOS transsistor (N14) is connected to the second input (IN2) of the differential amplifier (D) and to an eighth CMOS current source (I8).

8. An oscillator according to claim 2 which is so designed that the fourth current source (I4) delivers a current of greater value than the sum of the currents from the first, second, and third current sources.

9. An oscillator according to any one of the preceding claims with the following combination of features:
- The first controlled current source (I1) and the second controlled current source (I2) are identical in construction and deliver equal currents, and

- the first resistor (R1) and the second resistor (R2) are equal in value.

10. An oscillator according to any one of the preceding claims which is implemented in complementary CMOS technology.

**Revendications**

1. Oscillateur en technique CMOS, comportant
- un amplificateur différentiel (D),
- un premier organe de commutation (S1), constitué d'un premier élément de commutation (SE1) et d'un second élément de commutation (SE2),
- un second organe de commutation (S2) constitué d'un troisième élément de commutation (SE3) et d'un quatrième élément de commutation (SE4),
- une première (I1) et une seconde (I2) sources de courant pilotables qui sont reliées ensemble par l'intermédiaire d'un condensateur (C),
- et présentant la structure suivante
- la première source de courant (I1) est reliée, par l'intermédiaire d'une première résistance ohmique (R1), avec une première entrée (IN1) de l'amplificateur différentiel (D) et la seconde source de courant (I2) est reiiée, par l'intermédiaire d'une seconde résistance ohmique (R2), avec une seconde entrée (IN2) de l'amplificateur différentiel (D),
- une borne (VDD) amenant une tension d'alimentation peut être reiiée, par l'intermédiaire du chemin de mise en circuit du premier élément de commutation (SE1), avec un premier point de prélèvement (A1) situé entre la première source de courant (I1) et la première résistance (R1) et peut être reliée, par l'intermédiaire du chemin de mise en circuit du second élément de commutation (SE2), avec un second point de prélèvement (A2) situé entre la seconde source de courant (I2) et la seconde résistance (R2),
- une première sortie (OUT1) de l'amplificateur différentiel (D) est reliée avec une première entrée de commutation du premier élément de commutation (SE1) et une seconde sortie (OUT2) de l'amplificateur différentiel (D) est reliée avec une entrée de commutation du second élément de commutation (SE2),
- la première entrée (IN1) de l'amplificateur différentiel (D) peut être reliée, par l'intermédiaire d'un chemin de mise en circuit du troisième élément de commutation (SE3), avec une troisième source de courant (I3) réalisée en technique CMOS et la seconde entrée (IN2) de l'amplificateur différentiel (D) peut être reliée, par l'intermédiaire d'un chemin de mise en circuit du quatrième élément de commutation (SE4), avec cette même troisième source de courant (I3), et

- une entrée de commande du troisième élément de commutation (SE3) est reliée avec la première sortie (OUT1) de l'amplificateur différentiel (D) et une entrée de commande du quatrième élément de commutation (SE4) est reliée avec la seconde sortie (OUT2) de l'amplificateur différentiel (D).

2. Oscillateur selon la revendication 1, présentant la combinaison suivante de caractéristiques

- le premier élément de commutation (S1) est constitué d'un premier transistor NMOS (N1) formant le premier élément de commutation (SE1), d'un second transistor NMOS (N2) formant le second élément de commutation (SE2), d'un premier circuit symétrique constitué d'un premier transistor PMOS (P1) et d'un second transistor PMOS (P2) et d'un second circuit symétrique constitué d'un troisième transistor PMOS (P3) et d'un quatrième transistor PMOS (P4),

- la branche du courant de sortie (drain de P1) du premier circuit symétrique est reliée avec le premier point de prélèvement (A1) et la branche du courant de sortie (drain de P4) du second circuit symétrique est reliée avec le second point de prélèvement (A2),

- la branche du courant de référence du premier circuit symétrique peut être reliée, par l'intermédiaire du chemin de mise en circuit du premier transistor NMOS (N1), avec une quatrième source de courant (I4) réalisée en technique CMOS et la branche du courant de référence du second circuit symétrique peut être reliée, par l'intermédiaire du chemin de mise en circuit du second transistor NMOS (N2), avec cette même quatrième source de courant et

- la borne de grille du premier transistor NMOS (N1) forme l'entrée de commande du premier élément de commutation (SE1) et la borne de grille du second transistor NMOS (N2) forme l'entrée de commande du second élément de commutation (SE2).

3. Oscillateur selon la revendication 1 ou 2, présentant la combinaison suivante de caractéristiques

- le second organe de commutation (S2) est constitué d'un troisième transistor NMOS (N3) formant le troisième élément de commutation (SE3) et d'un quatrième transistor NMOS (N4) formant le quatrième élément de commutation (SE4),

- la première résistance (R1) peut être reliée, par l'intermédiaire du chemin de mise en circuit du troisième transistor NMOS (N3), avec la troisième source de courant (I3) et la seconde résistance (R2) peut être reliée, par l'intermédiaire du chemin de mise en circuit du quatrième transistor NMOS (N4), avec cette même troisième source de courant et

- la borne de grille du troisième transistor NMOS (N3) est reliée avec la première sortie (OUT1) et la borne de grille du quatrième transistor NMOS (N4) est reliée avec la seconde sortie (OUT2) de l'amplificateur différentiel (D).

4. Oscillateur selon l'une des revendications précédentes, présentant la combinaison suivante de caractéristiques

- l'amplificateur différentiel (D) est constitué d'un premier étage amplificateur différentiel (N5, N6, N7, N8, I5) et d'un second étage amplificateur différentiel (N9, N10, N11, N12, I6), qui sont reliés en cascade.

5. Oscillateur selon la revendication 4, présentant la combinaison suivante de caractéristiques

- le premier étage de l'amplificateur différentiel contient un cinquième transistor NMOS (N5) et un sixième transistor NMOS (N6) dont les bornes de grille et les bornes de drain sont reliées avec la borne (VDD) amenant la tension d'alimentation,

- la borne de source du cinquième transistor NMOS (N5) forme la première sortie (OUT1) et la borne de source du sixième transistor NMOS (N6) forme la seconde sortie (OUT2) de l'amplificateur différentiel (D),

- le premier étage de l'amplificateur différentiel contient un septième (N7) et un huitième transistor NMOS dont les bornes de source sont reliées avec une cinquième source de courant (I5) réalisée en technique CMOS,

- la borne de drain du septième transistor NMOS (N7) est reliée avec la borne de source du cinquième transistor NMOS (N5) et la borne de drain du huitième transistor NMOS (N8) est reliée avec la borne de source du sixième transistor NMOS (N6) et

- la borne de grille du septième transistor NMOS (N7) forme une première entrée du premier étage de l'amplificateur différentiel et la borne de grille du huitième transistor NMOS (N8) forme une seconde entrée de ce premier étage de l'amplificateur différentiel.

6. Oscillateur selon la revendication 5, présentant la combinaison suivante de caractéristiques

- le second étage de l'amplificateur différentiel contient un neuvième transistor NMOS (N9) et un dixième transistor NMOS (N10) dont les bornes de grille et les bornes de drain sont reliées avec la borne (VDD) amenant la tension d'alimentation,
- la borne de source du neuvième transistor NMOS (N9) est reliée avec la seconde entrée du premier étage de l'amplificateur différentiel (N5, N6, N7, N8, I5) et la borne de source du dixième transistor NMOS (N10) est reliée avec la première entrée de ce premier étage,
- le second étage de l'amplificateur différentiel contient un onzième conducteur NMOS (N11) et un douzième transistor NMOS (N12) dont les bornes de source sont reliées avec une sixième source de courant (I6) réalisée en technique CMOS,
- la borne de drain du onzième transistor NMOS (N11) est reliée avec la borne de source du neuvième transistor NMOS (N9) et la borne de drain du douzième transistor NMOS (N12) est reliée avec la borne de source du dixième transistor NMOS (N10) et
- la borne de grille du onzième transistor NMOS (N11) forme la première entrée (IN1) de l'amplificateur différentiel (D) et la borne de grille du douzième transistor NMOS (N12) forme la seconde entrée (IN2) de l'amplificateur différentiel (D).

7. Oscillateur selon l'une des revendications précédentes, présentant la combinaison suivante de caractéristiques

- la borne de la première résistance (R1) située du côté opposé au premier point de prélèvement (A) est reliée avec la borne de grille d'un treizième transistor NMOS (N13) et la borne de la seconde résistance (R2) située du côté opposé au second point de prélèvement (A2) est reliée avec la borne de grille d'un quatorzième transistor NMOS (N14),

- les bornes de drain du treizième et du quatorzième transistors NMOS (N14) sont reliées avec la borne (VDD) amenant la tension d'alimentation,
- la borne de source du treizième transistor NMOS (N13) est reliée avec la première entrée (IN1) de l'amplificateur différentiel (D) et avec une septième source de courant (I7) réalisée en technique CMOS et
- la borne de source du quatorzième transistor NMOS (N14) est reliée avec la seconde entrée (IN2) de l'amplificateur différentiel (D) et avec une huitième source de courant (I8) réalisée en technique CMOS.

8. Oscillateur selon la revendication 2, dimensionné de façon que la quatrième source de courant (I4) fournisse, en valeur absolue, une intensité supérieure à l'intensité résultant de l'addition de la première, de la deuxième et de la troisième sources de courant.

9. Oscillateur selon l'une des revendications précédentes, présentant la combinaison suivante de caractéristiques

- la première source de courant pilotable (I1) et la seconde source de courant pilotable (I2) sont réalisées de façon identique et fournissent les mêmes intensités et
- la première résistance ohmique (R1) et la seconde résistance ohmique (R2) présentent les mêmes valeurs de résistance.

10. Oscillateur selon l'une des revendications précédentes, dans lequel l'oscillateur est réalisé en technique CMOS complémentaire.

FIG.1

FIG.2

I1, I2 ~ I$_{Steuer}$

FIG.3

FIG.4A

FIG.4B

FIG.4C

FIG.4D

FIG.4E